# EUROPEAN PATENT APPLICATION

(11) **EP 1 739 834 A1**
(43) Date of publication of application: **03.01.2007**
(21) Application number: 05014018.5
(22) Date of filing: 29.06.2005
(51) Int. Cl.: H03K 17/042, H03K 17/687

(54) **An analogue switch, a switch system and a method for use therewith**

(71) Applicant: Svenska Grindmatriser AB, 581 31 Linköping (SE)
(72) Inventor: Landelius, Lars, 596 92 Skänninge (SE); Montelius, Mikael, 583 31 Linköping (SE)
(74) Representative: Willquist, Bo Lorentz

(57) **Abstract**

An analogue switch (100) is provided, comprising a first transistor (101) formed with an isolated body having one end of its conducting channel connected to the input (102) and the other end connected to the output (103). The analogue switch (100) also comprises a body potential control circuitry (120) arranged to set a body potential (105) of the first transistor to the potential of the input or output that constitutes the source of the first transistor (101). A gate potential control circuit sets the gate of the first transistor (101) to the body potential (105) to set the switch (100) in the "off state", or sets the gate of the first transistor (101) to a voltage level that differs from the body potential (105) to set the switch (100) in the "on state". A switch system comprising such analogue switches and a method for providing an analogue switch are also disclosed.

## Description

### Field of the invention

The present invention relates to an analogue switch comprising a transistor with an isolated body. More specifically it relates to a switch of the type that can be implemented as, or in, an integrated circuit.

### Background

In many applications, such as in test and measurement applications or RF-applications, it is often desirable to switch analogue signals at high frequencies, often in close connection with digital circuitry and signals, e.g. demodulated digital data that has been received as RF-signals and/or data that are to be transmitted as RF-signals, or digital control logic. Preferably, an analogue switch is integrated on-chip together with the digital logic, however, more often than not, this is not possible, especially if the signal being switched is of high frequencies and contains voltages that is above what a conventional integrated circuit for digital logic can handle. For use in a specific frequency range, a switch must typically maintain properties within certain limits throughout that range, e.g. regarding low insertion loss, low "on" resistance, high "off" isolation, switching speed etc. Typically there is a deterioration of properties at high frequencies, making it a challenge to accomplish switches that exhibit properties that are within the limits at high frequencies.

Hence, to be able to meet up with high requirements regarding frequency and voltage, in many applications often the only viable alternative is a separate switch component, e.g. a Reed relay or Reed switch. However, this is neither cost nor area efficient. Further, component solutions involving mechanical parts may typically suffer from restricted switching speed and from wear related problems, which for example results in an uncertain level of reliability and a life cycle being shorter than what is desirable. Accordingly, there is a need for an analogue switch that admit switching of relatively high voltages at high frequencies and that can be manufactured as an integrated circuit, i.e. as a stand alone integrated circuit or combined with other circuitry, e.g. digital logic and/or analogue functions, in an application specific circuit or similar.

US6804502 discloses a switch circuit for switching RF-signals which comprises CMOS devices implemented on a silicon-on-insulator (SOI) substrate.

EP995269 discloses an analogue switch circuit targeted for improved off-isolation, comprising CMOS transistors formed in wells of the substrate that are isolated.

However, the circuits disclosed in these documents suffer from similar problems as mentioned above.

### Summary of the invention

An object of the invention is to overcome or at least alleviate the problems experienced in the prior art. A specific object is to provide an improved analogue switch that can handle high frequencies and voltages, and that can be implemented as, or in, an integrated circuit.

The invention is defined by the appended independent claims. Preferred embodiments are set forth in the dependent claims and in the following description and drawings.

Hence, according to a first aspect, there is provided an analogue switch having an "on state" for passing of signals between an input and an output and an "off state" for blocking of signals between the input and the output, the switch comprising a first transistor formed with an isolated body having one end of its conducting channel connected to the input and the other end connected to the output, a body potential control circuitry arranged to set a body potential of the first transistor to the potential of the input or output constituting the source of the first transistor, a gate potential control circuitry arranged to, on the basis of a control signal, control the gate of the first transistor to set the switch in the "on state" or "off state", wherein the gate potential control circuitry is arranged to set the gate of the first transistor to the body potential to set the switch in the "off state", and arranged to set the gate of the first transistor to a voltage level that differs from the body potential by a predefined drive voltage level to set the switch in the "on state".

"Analogue switch" is referring to a solid state electrical switch placed in a signal path between an input and output and arranged to selectively block or pass a signal between the output or input depending on the state of a control signal.

"Source" is referring to the conducting channel terminal of a transistor where charges enter the transistor. For example, in a PMOS transistor, the source is defined by the end of the conducting channel having the highest potential and the drain by the lowest potential. In an NMOS transistor, the source is defined by the end of the conducting channel having the lowest potential and thus the drain by the highest potential. The denomination "source" and "drain" is typically associated with field effect transistors (FET).

"Isolated body" is referring to a transistor formed to be electrically insulated from the underlying substrate. This could be an NMOS transistor in a P-well, a PMOS transistor in an N-well or an NMOS or PMOS transistor formed in a silicon on insulator (SOI) process. The degree of isolation should preferably be sufficiently high to provide only small parasitic capacitances between the transistor and the substrate throughout the frequency range for which the transistor is used. The degree of isolation should preferably be sufficient so as to allow transistors having their body connected to a signal being switched, to be charged quickly enough to be able to "float" with and follow the signal, even at higher frequencies. For example, in order to achieve 1 dB insertion loss for a 1 GHz switch it may only be allowed to have a total capacitive load of approximately 3 pF and for a 4 GHz switch, approximately 1 pF, i.e. for switches for 1 GHz and above, the capacitive load typically should be about or below 3 pF.

A "floating" switch is thus accomplished, wherein the first transistor has a "floating" body and a "floating" gate drive, i.e. a body potential and gate potential that follows the signal being switched. In the "on state" the first transistor follows the signal being passed between the input and the output and in the "off state", the transistor follows the voltage difference between the input and the output terminal, i.e. the signal applied to the switch. The voltage range that can be handled is thus essentially the same in both states. The resulting "floating" switch provides efficient utilization of the available transistor voltage range and reduction of capacitances that are in need to be charged, thus offering improvements both regarding allowed switching voltages and switching of high frequency signals. Further, low insertion loss is accomplished, for example the on-resistance will be essentially independent of the signal being switched due to the gate-source voltage that is being kept at essentially fixed predetermined levels. Moreover, since body and gate potentials at a maximum will differ by the predetermined drive voltage level, it can be ensured that the body-gate voltage is kept within an allowable range, independent of the signal being switched.

The gate potential control circuitry may comprises a gate drive circuitry having the body potential as input, and which may be arranged to generate the predefined drive voltage level and add the body potential to said predefined drive voltage level.

The gate potential control circuitry may comprise a second transistor formed with an isolated body, the second transistor may have its isolated body and source connected to the body potential of the first transistor, wherein the second transistor may have drain connected to the gate of the first transistor.

The second transistor provides a reduction of the load experienced by the switch in the "off state". It also facilitates in providing a switch that can handle essentially equal potential differences in both states.

The gate drive circuitry may comprise a first drive output connected to the gate of the first transistor and a second drive output connected to the gate of the second transistor, wherein the first drive output and the second drive output may be controllable by the control signal to set the first drive output to a voltage level that differs from the body potential by the predefined drive voltage level and set the second drive output to the body potential to set the switch in the "on-state", and may be controllable by the control signal to set the first drive output in a high impedance state and set the second drive output to a voltage level that differs from the body potential by the predefined drive voltage level to set the switch in the "off-state".

In an embodiment, the body potential control circuitry may comprise two transistors, each formed with an isolated body, the transistors may have their respective isolated body connected to the body potential of the first transistor, wherein the two transistors may be arranged to set the body potential to the potential of the input or output constituting the source of the first transistor.

An advantage of this is that the body of the first transistor will always be coupled to source independent of the signal being applied to the switch. Thus, neither the input nor the output of the switch is required to be biased and kept at an higher or lower potential than the other in order to ensure that the body is biased correctly in relation to the source, i.e. typically to ensure that a forwardly biased diode-junction is not formed.

At least part of the switch circuitry may be fabricated in a silicon on insulator (SOI) process.

SOI is currently a predominant way of providing a transistor with a high degree of isolation between the body and substrate. Using SOI technology greatly reduces parasitic capacitances, allowing for faster switching and improved high frequency characteristics.

In an embodiment, at least one, and preferably all, transistors that form the switch, may be low-voltage transistors.

For being able to integrate the switch with conventional and predominant low-voltage circuits and being able to manufacture it using conventional and low-voltage processes, thus reducing cost, the switch is preferably implemented using low-voltage transistors, e.g about or below 5 V.

In an embodiment, the switch may be symmetrical.

A symmetrical switch, i.e. symmetrical with respect to its input and output, has the advantage that it exhibit the same behavior and characteristics in both directions, i.e. the input and output may be interchanged and the switch may be used in opposite direction with the same result. This is often desired for multi-purpose switches and switches that must be able to handle communications in two directions.

According to a second aspect there is provided an analogue switch system, comprising a switch system input and a switch system output, first and second analogue switches arranged in series in a signal path between the switch system input and the switch system output.

"Floating" switches of the type described herein that are connected in series provide the advantage that the signal voltages being passed are split between the switches, thus providing a switch system that can handle signal voltages that are larger than what can be applied to and handled by a single component part switch, i.e. an extended voltage range is provided. The switch system can use low voltage switches to provide a high voltage switch, still taking advantage of the properties of the component part low-voltage switches. Provided that the switches has an equal on-resistance, two switches in series means that the switch system can handle twice the voltage range that can be handled by a single switch. The effect may be enhanced by connecting more than two switches in series.

In an embodiment, there may be a third analogue switch connected between a predefined DC voltage level and a node located in the signal path between the first switch and the second switch, the third analogue switch may be arranged to drive the node to the predefined DC-voltage level and ground AC-signals occurring at the node when first and second analogue switches are non-conducting and the switch system is in an "off state", and may be arranged to disconnect the node from the predefined DC-voltage level when first and second analogue switches are conducting and the switch system is in an "on state".

This results in a switch system, having improved off-isolation due to the grounding of any occurring AC-signals and that can handle higher signal voltages in its "off state" than what can be handled by a single component switch, i.e. the allowed voltage range is extended. When two switches are connected in series, the predefined DC-voltage level is typically set to a level approximately in the middle of the switch system signal voltage range such that each of the component switches may experience only about half of the voltage difference between the input and the output.

According to a third aspect there is provided an integrated circuit having at least one switch or switch system.

This makes it possible to manufacture a small switch at low costs, which may be integrated with other circuitry e.g. to provide efficient on-chip solutions and application specific circuits.

According to a fourth aspect there is provided a method for providing an analogue switch having an "on state" for passing of signals between an input and an output, and an "off state" for blocking of signals between the input and the output, the method comprising the steps of: providing a first transistor formed with an isolated body having one end of its conducting channel connected to the input and the other end connected to the output, setting a body potential of the first transistor to the potential of the input or output constituting the source of the first transistor, controlling the gate of the first transistor to set the switch in the "on state" or the "off state", wherein setting of the gate of the first transistor to the body potential sets the switch in the "off state", and setting the gate of the first transistor to a voltage level that differs from the body potential by a predefined drive voltage level sets the switch in the "on state".

Hereby, similar advantages are achieved as presented above in connection with the other aspects of the invention.
In an embodiment, the step of controlling the gate of the first transistor may comprise the sub-steps of: measuring the body potential of the first transistor, generating a predefined drive voltage level, and adding the predefined drive voltage level to the measured body potential.

### Brief description of the drawings

For exemplifying purposes, embodiments of the invention will now be described with reference to the appended drawings, wherein:
Fig. 1 is a schematic view of an analogue switch on transistor level, in accordance with one embodiment of the invention.
Fig. 2 is a flow chart illustrating a method for controlling an analogue switch, according to an embodiment of the invention.
Fig. 3 is a schematic transistor level view of a gate drive circuitry of the analogue switch of Fig. 1.
Fig. 4 is schematic view of a switch system comprising analogue switches, according to an embodiment of the invention.

### Description of embodiments

The invention will now be described with reference to embodiments.

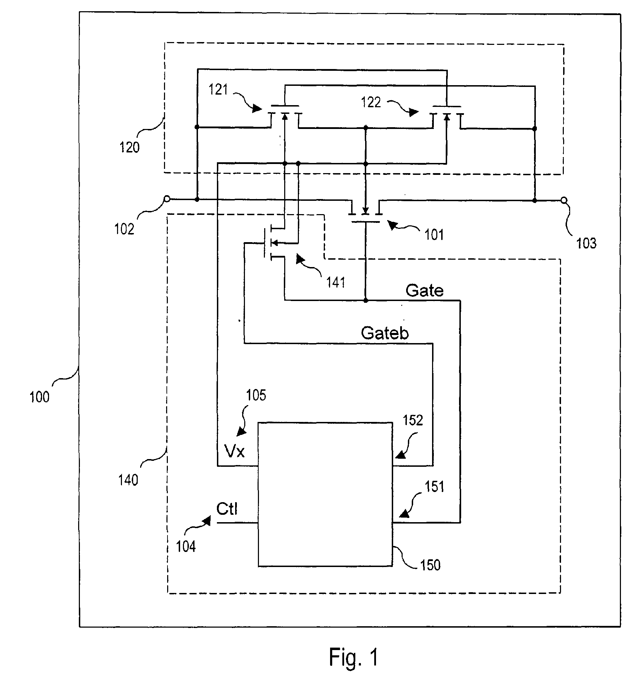

Referring to Fig. 1, an example of an analogue switch 100 on transistor level will now be described.

The transistors shown are MOSFETs, which preferably have highly isolated bodies presenting very small parasitic capacitances between the body and any underlying substrate; the transistors e.g. may be accomplished by use of a silicon-on-insulator (SOI) process and be SOI CMOS transistors. Located in a transmission path between an input terminal 102 and an output terminal 103 there is an NMOS transistor 101 having one end of its conducting channel connected to the input 102 of the switch and the other end connected to the output 103. The transistor 101 has an ON-state in which the transistor 101 is conducting and signals from the input 102 are transmitted to the output 103, and an OFF-state in which the transistor 101 is non-conducting and signals are blocked between the input 102 and the output 103. In order to achieve low on-resistance and low insertion loss, the transistor 101 preferably is designed, typically by size, to have low on-resistance in relation to impedances at the input 102 and output 103. For example, for use in a 50 Ohm system the on-resistance for transistor 101 may be about 3 Ohm. However, since a decrease of on-resistance typically means increase of capacitance, and thus a decrease in speed, typically the on-resistance can not be made too small in practice. An acceptable trade-off typically has to be considered by a person skilled in the art on a case to case basis, and typically will e.g. depend on the process being used, switch requirements etc.

The body of the transistor 101 in Fig. 1 is controlled and set to a body potential 105 by a circuitry 120 indicated by a dotted line in Fig. 1. In the example shown, the circuitry 120 has two NMOS-transistors 121, 122 connected in series, i.e. one end of the conducting channel of transistor 121 is connected to one end of the conducting channel of transistor 122. The interconnected part is further connected to a body terminal of transistor 101. The other end of respective transistor 121, 122 is connected to the input 102 and output 103, respectively. Furthermore, the gate of transistor 121 is connected to the output 103 and the gate of transistor 122 to the input 102. As will be appreciated by the person skilled in the art, the circuitry 120 presents an example of a circuitry that will couple the body of transistor 101 to the lowest potential of the input 102 or output 103, i.e. the potential that defines the source of NMOS transistor 101, while at the same time the body of the transistor 101 will "float" with the input signal or output signal, depending on which that is connected to the body terminal of transistor 101, i.e. the body of transistor 101 will follow the lowest potential of the input 102 or output 103 and thus following a signal being applied to the switch 100.

It should be noted that the denominations "input" and "output" are only exemplifying and selected for the purpose of presentation, and is not used herein to indicate in which direction charges flows or in which direction a user chooses to pass signals.

In an alternative embodiment, the transistors 101, 121 and 122 are of PMOS-type, and thus the source is constituted by the end of the conducting channel having the highest potential, and the circuitry 120 connects the body of the transistor 120 to the highest potential of input 102 or output 103.

It will be appreciated that the circuitry 120 has a symmetrical design not requiring the input 102 or output 103 to be biased and kept at an higher or lower potential than the other, in order to ensure that the body of transistor 101 is suitably biased in relation to the substrate, i.e. typically to ensure a non-forward biased diode-junction.

In another embodiment, the body of the transistor 101 is directly connected to the source of the transistor 101.

Other alternatives to the circuitry 120 as shown in Fig. 1, may comprise more advanced solutions providing the same effect, namely setting the body potential of transistor 101 to the source. One alternative may involve using a pair of two opposite directed diodes that respectively connects the input and output to the body of transistor 101.

In order to control the gate of transistor 101 and thus setting the switch 100 and the transistor 101 in the ON-state or OFF-state, there is a circuitry 140, indicated by another dotted line in Fig. 1, which comprises an NMOS transistor 141 connected between the body terminal and the gate terminal of transistor 101.

In an alternative embodiment, the transistor 141 is of PMOS type, which typically is the case when the transistor 101 is of PMOS-type.

Still referring to Fig. 1, the transistor 141 has its body connected to the body of transistor 101, i.e. there is a common body potential (Vx) 105 following the voltage level of the signal at the input or output, depending on which of the two that is coupled to the body terminal of transistor 101 by circuitry 120, i.e. the body of transistor 141 will also "float" and follow a signal being switched as is the case of transistor 101. The gate of transistor 141 is connected to an output 152 (Gateb) of a gate drive circuitry 150, which provides a gate potential for control of transistor 141. The source of transistor 141 is connected to the common body potential 105 (Vx) and the drain is connected to the gate of transistor 101. The gate of transistor 101 also is connected to another output 152 (Gate) of the gate drive circuitry 150, which provides a gate potential for control of transistor 101.

The gate drive circuitry 150 measures the common body potential 105 (Vx) and uses it as an input to generate gate drive voltages in relation to the common body potential 105 (Vx) in order to accomplish a "floating" gate drive for use with transistors 101, 141. The isolated bodies of transistors 101 and 141 are interconnected and connected to the respective source terminal. In order to produce a gate-source control voltage for setting any of transistors 101 or 141 in an ON-state, the gate drive circuitry 150 adds the common body potential to a predefined drive voltage level, typically being a multiple of a threshold voltage VT of the transistors being controlled, preferably 2*VT. It should be noted that in case of an integrated circuit, typically the threshold voltage follows from the process being used in fabrication of the circuits; for example, the threshold voltage may be about 2 V for 5 V CMOS transistors.

On the basis of a switch control signal 104 (Ctl), having a high and a low state, the gate drive circuitry 150 controls transistors 101, 141 in order to set the switch 100 in the ON-state or OFF-state.

When the control signal 104 is set high and the switch is to be set in its ON-state, the circuitry 150 drives the output 151 (Gate) to the predefined drive voltage level added to the measured common body potential level 105 (Vx), i.e. to a potential that differs from the common body potential and the source by the predefined drive voltage level, and drives the output 151 (Gateb) to the common body potential 105 (Vx).

When the control signal 104 (Ctl) is set low and the switch 100 is to be set in its OFF-state, the circuitry 150 sets its output 151 (Gate) to a high impedance state and its output 152 (Gateb) to the predefined drive voltage level added to the common body potential 105 (Vx). This results in that transistor 141 is switched ON and starts to conduct, thereby setting the gate of transistor 101 to the common body potential 105 (Vx).

Thus, transistors 101 and 141 is set to opposite states, for example, when transistor 101 is conducting and in an ON-state, transistor 141 is non-conducting and in an OFF-state, and vice versa. Still, both transistors 101, 141 will "float" and follow the signal being conducted between the input 101 and output 103 when the switch 100 is in its ON-state, or follow the potential of the switch input 102 or output 103 when the switch is in its OFF-state.

When the switch 100 is implemented using only NMOS transistors as shown in Fig. 1, the full supply voltage range cannot be utilized for signals being switched. This is due to that a voltage range corresponding to the predefined drive voltage level must be left between the most positive supply voltage and the maximum allowed input signal, in order to be able to control the switch 100. In case of an implementation using PMOS transistors, a corresponding situation occurs, which requires a voltage range to be left unused between the most negative supply voltage and the maximum allowed negative input signal. To be able to switch signals using a full supply voltage range, an implementation of the switch 100 using NMOS transistors may be connected in parallel with a corresponding implementation using PMOS transistors. The switch being formed is then arranged to let the NMOS part switch negative voltages and the PMOS part switch positive voltages. However, it should be noted that this solution requires about twice as many transistors and twice the area of a single NMOS or PMOS switch solution. Often it is therefore, when possible, still a better solution to use a single NMOS or PMOS solution.

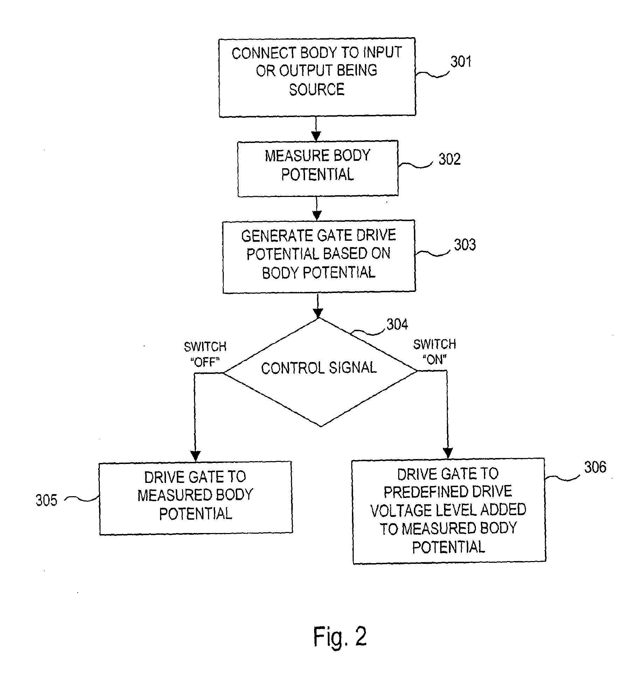

Referring to Fig. 2, there is shown a flow chart providing an overview of some of the actions executed by the switch 100. In a step 301, the body of the first transistor 101 is set to the potential of the input 102 or output 103 of the switch 100 that constitutes the source. In another step 103, the body potential 105 (Vx) of the first transistor is measured and used in yet another step 303 to generate a gate drive potential. In a step 305, when the control signal indicates that the switch should be in its OFF-state, the gate of the first transistor 101 is set to a gate drive potential being equal to the measured body potential. In a step 306, when the control signal 104 indicates that the switch 100 should be in its ON-state, the gate of the first transistor 101 is set to a gate drive potential being the predefined drive voltage level added to the measured body potential 105 (Vx).

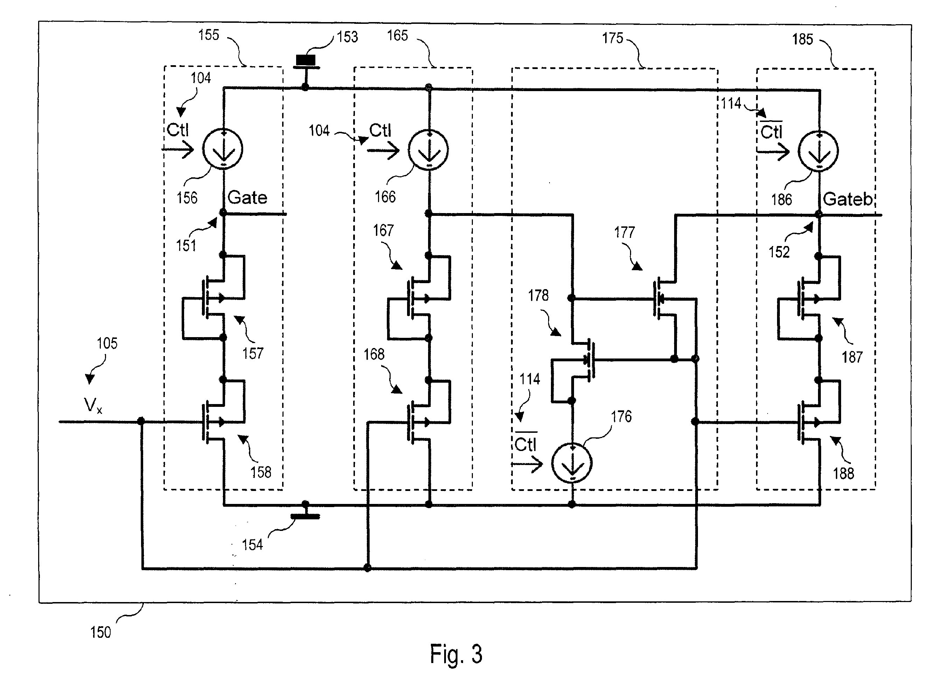

Referring to Fig. 3, an example of the gate drive circuitry 150 on transistor level, implemented using current generators, will now be described.

For purpose of presentation, the circuitry 150 shown in the figure has been divided into blocks 155, 165, 175 and 185. It will be appreciated that blocks 155, 165 and 185 technically have a similar and corresponding construction.

In block 155, a current generator 156 is connected between the most positive supply line voltage 153 and the source of a first PMOS transistor 157, which in turn has its drain connected to the source of a second PMOS transistor 158 that has its drain connected to the most negative supply line voltage 154.

In the figure, the transistors 157 and 158 have their respective body terminals connected to source and the drain of transistor 157 is connected to its gate. The gate of transistor 158 is connected to the common body potential 105 (Vx) and the current generator 156 is controlled by the control signal 104 (Ctl).

When the current generator 156 is on, i.e. the control signal 104 (Ctl) is high, transistors 157 and 158 are conducting and thus providing a threshold voltage VT as source-gate voltage. Since the transistor 158 has the common body potential 105 as gate voltage, the potential at the source of transistor will be Vx+2VT, i.e. a predefined drive voltage level being two times the threshold voltage (VT) added to the common body potential 105 (Vx). Thus. a potential level corresponding to the body potential 105 (Vx) raised by 2VT is achieved.

When the current generator 156 is off, i.e. the control signal 104 (Ctl) is low, the transistors 157, 158 are off, and the node at the source of transistor 157, i.e. between the current generator 156 and the transistor 157, will be in a high impedance state.

Only block 155 was described above, however, the skilled person easily realizes that a corresponding description also applies for block 165 and 185.

As indicated in the figure, block 155 is for providing the output 151 (Gate) at the node between the current generator 156 and the transistor 157.

As also indicated, the node between the current generator 186 and the transistor 187 in block 185 is for providing the output 152 (Gateb). The current generator 186 is controlled by a control signal 114 being an inverse of the control signal 104 (Ctl).

As indicated in the figure, there is a connection from block 175 to the output 152 (Gateb) in block 185. Block 165, 175 and 185 are arranged to provide the desired voltages at output 152 (Gateb). Block 175 interconnects the blocks 165, 185 and comprises two NMOS transistor 177, 178, and a current generator 176 connected between the source of the transistor 178 and the most negative supply line voltage 154. Both transistors 177, 178 have their body terminals connected to source. Moreover, the node of block 165 that is located between the current generator 166 and the transistor 167, is connected to the drain of transistor 178 and the gate of transistor 177. The gate of transistor 178 and the source of transistor 177 are connected to the common body potential 105 (Vx). The drain of transistor 177 connects to the output 152 (Gateb).

When the control signal 104 (Ctl) is high, the node between the current generator 166 and the transistor 167 of block 165 will be Vx+2VT. Current generator 176 of block 175 is off and thus transistor 178 is in a high impedance state. Thus, the Vx+2VT voltage from block 165 is applied to the gate of transistor 177, which consequently receives a gate-source voltage of 2VT and starts to conduct, resulting in that the output 152 (Gateb) connects to the common body potential 105 (Vx). At the same time, the control signal 114 is low, which results in that current generator 186 and the transistors 187, 188 are off and in a high impedance state in relation to the output 152 (Gateb), and thus the output 152 (Gateb) is set to the common body potential 105 (Vx).

When the control signal 104 (Ctl) is low, the node between the current generator 166 and the transistor 167 of block 165 will be in a high impedance state relative to the gate of transistor 177. Current generator 176 will be on and thus transistor 178 will conduct and drive the gate of transistor 177 to VT below Vx. The gate-source voltage of transistor 177 thus becomes -VT, which always is a negative voltage and thus transistor 177 will be off and presenting a high impedance with respect to the output 152 (Gateb).

The voltage at the output 152 (Gateb) is generated by block 185 in line with the above description regarding block 155, however, block 185 is controlled by a control signal 114 being the inverse of the control signal 104, and the output 152 (Gateb) is set to Vx+2VT when the control signal 104 is low.

In an alternative embodiment, the PMOS transistors 157, 167 and 187 may be replaced by one or more NMOS transistors connected in series to achieve a threshold voltage (VT) matching to the transistor 101.

Alternatives to the gate drive circuitry as shown in Fig. 3 may for example be based on a voltage follower and an adder circuitry arranged to follow the common body potential 105 (Vx) and add the predetermined gate drive voltage level.

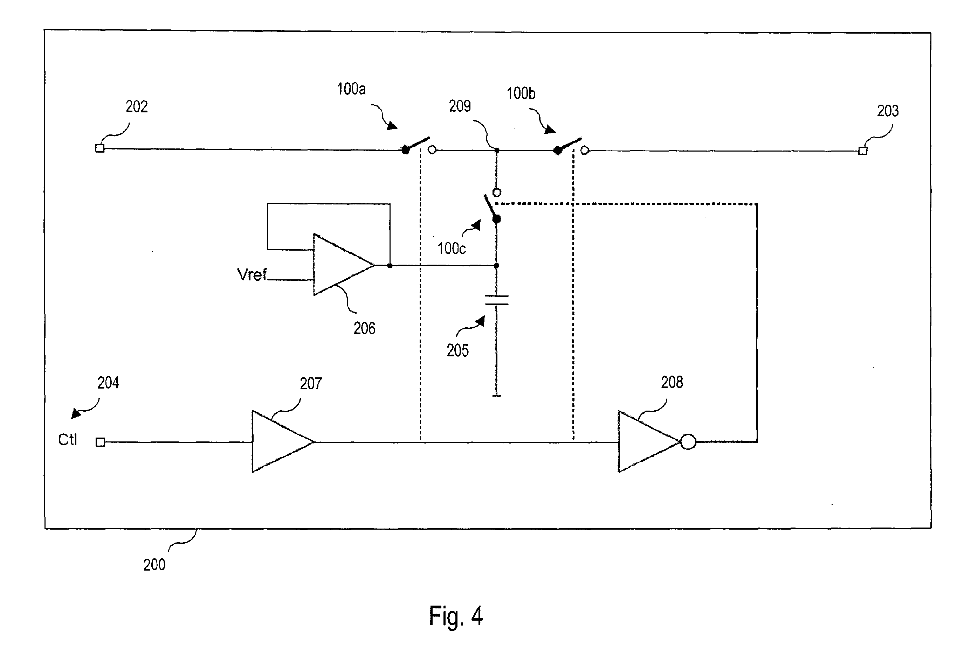

Referring to Fig. 4, an example of a switch system 200 utilizing switches 100 as previously described, i.e. switches having a "floating" body and "floating" gate drive which make the switches "float" with and follow the signal being switched, will now be described.

The switch system 200 has a switch system input 202 and a switch system output 203. Between the input and the output, there are a first switch 100a and a second switch 100b connected in series. Between the output of the first switch 100a and the input of the second switch 100b there is a node 209, which is connected to a third switch 100c. The third switch 100c is also connected to a voltage buffer 206 that is controllable for biasing the node 209 at a predetermined DC-level when the third switch is in its ON-state. Between ground and the node 209 there is connected a capacitor 205.

On the basis of a control signal 204, the switches 100a, 100b, 100c may be set to an ON-state or OFF-state in accordance with the previous description.

In the example of Fig. 4, a common control signal 204 is connected to a buffer 207, and the switches 100a and 100b are controllable by the control signal 204 after passing of the buffer 207. An inverter 208, produces an inverse of the control signal 204. The switch 100c is controllable by the inverse of control signal 204.

The switches 100a, 100b preferably are controllable, by the common control signal 204.

When the switch system 200 is in an ON-state, the first and second switches 100a, 100b are in their ON-states, and thus electrically connecting the input 202 with the output 203 for passing of signals. The switch 100c is at the same time in its OFF-state, disconnecting the node 209 and letting it "float" with the signal being passed by the switch system. As a consequence, since the switches 100a, 100b, as previously described, "float" and follow a signal being passed, the switch system 200 will also exhibit such behavior. A signal being passed will be divided between the two switches 100a and 100b, and approximately only half of the signal will burden each switch, provided that the switches have essentially the same on-resistance.

When the switch system 200 of the example is in an OFF-state, the first and second switches 100a, 100b are in their OFF-states, but the third switch 100c in its ON-state. The third switch 100c connects the predetermined voltage level provided by the voltage buffer 206 to the node 209 between switches 100a and 100b. The predetermined voltage level is preferably selected to be in the middle of the voltage range formed between the most negative signal voltage and the most positive signal voltage. This in order to ensure that each of the switches 100a and 100b will experience at maximum half of the signal voltage in their respective OFF-state.

If a symmetrical signal voltage range is used, no predetermined DC voltage level needs to be applied to achieve the above mentioned effect, and no voltage buffer 206 is needed, since 0 V per definition will be in the middle of a symmetrical range.

In the example of Fig. 4, AC-signals from the input 202 or output 203, which are not sufficiently blocked by switch 100a or 100b and that occur at node 209 in OFF-state of the switch system 200, will be grounded via capacitor 205.

In an alternative embodiment, the switch 100c may be of another type than the first and second switches 100a,100b.

Specific embodiments of the invention have been described. However, several alternatives are possible, as would be apparent for someone skilled in the art, and some of which have been indicated in the foregoing. Such and other obvious modifications must be considered to be within the scope of the present invention, as it is defined by the appended claims.

## Claims

1. An analogue switch (100) having an "on state" for passing of signals between an input (102) and an output (103) and an "off state" for blocking of signals between the input (102) and the output (103), the switch (100) comprising:
a first transistor (101) formed with an isolated body having one end of its conducting channel connected to the input (102) and the other end connected to the output (103),
a body potential control circuitry (120) arranged to set a body potential (105) of the first transistor (101) to the potential of the input (102) or output (103) constituting the source of the first transistor (101),
a gate potential control circuitry (140) arranged to, on the basis of a control signal (104), control the gate of the first transistor (101) to set the switch (100) in the "on state" or "off state", wherein the gate potential control circuitry (140) is arranged to set the gate of the first transistor (101) to the body potential (105) to set the switch (100) in the "off state", and arranged to set the gate of the first transistor (101) to a voltage level that differs from the body potential (105) by a predefined drive voltage level to set the switch (100) in the "on state".

2. The switch (100) as claimed in claim 1, wherein the gate potential control circuitry (140) comprises a gate drive circuitry (150) having the body potential (105) as input, and which is arranged to generate the predefined drive voltage level and add the body potential (105) to said predefined drive voltage level.

3. The switch (100) as claimed in claim 2, wherein the gate potential control circuitry (140) comprises a second transistor (141) formed with an isolated body, the second transistor (141) having its isolated body and source connected to the body potential (105) of the first transistor (101), wherein the second transistor (141) has its drain connected to the gate of the first transistor (101).

4. The switch (100) as claimed in claim 3, wherein the gate drive circuitry (150) comprises a first drive output (151) connected to the gate of the first transistor (101) and a second drive output (152) connected to the gate of the second transistor (141), wherein the first drive output (151) and the second drive output (152) are controllable by the control signal (104) to set the first drive output (151) to a voltage level that differs from the body potential (105) by the predefined drive voltage level and set the second drive output (152) to the body potential (105) to set the switch (100) in the "on-state", and controllable by the control signal (104) to set the first drive output (151) in a high impedance state and set the second drive output (152) to a voltage level that differs from the body potential (105) by the predefined drive voltage level to set the switch (100) in the "off-state".

5. The switch (100) as claimed in any one of the preceding claims, wherein the body potential control circuitry (120) comprises two transistors (121, 122), each formed with an isolated body, the transistors (121, 122) having their respective isolated body connected to the body potential (105) of the first transistor (101), wherein the two transistors (121, 122) are arranged to set the body potential (105) to the potential of the input (102) or output (103) constituting the source of the first transistor (101).

6. The switch (100) as claimed in any one of the preceding claims, wherein at least part of the switch circuitry is fabricated in a silicon on insulator (SOI) process.

7. The switch (100) as claimed in any one of the preceding claims, wherein at least one, and preferably all, transistors that form the switch (100), are low-voltage transistors.

8. The switch (100) as claimed in any one of the preceeding claims, wherein the switch (100) is symmetrical.

9. An analogue switch system (200), comprising
a switch system input (202) and a switch system output (203),
first and second analogue switches (100a, 100b) according to any one of the claims 1-8 arranged in series in a signal path between the switch system input (202) and the switch system output (203).

10. The analogue switch system (200) as claimed in claim 9, further comprising
a third analogue switch (100c) connected between a predefined DC voltage level and a node (209) located in the signal path between the first switch (100a) and the second switch (100b),
the third analogue switch (100c) being arranged to set the node (209) to the predefined DC-voltage level and ground AC-signals occurring at the node (209) when first and second analogue switches (100a, 100b) are non-conducting and the switch system (200) is in an "off state", and arranged to disconnect the node (209) from the predefined DC-voltage level when first and second analogue switches (100a, 100b) are conducting and the switch system (200) is in an "on state".

11. An integrated circuit having at least one switch (100) or switch system (200) according to any one of the claims 1-10.

12. A method for providing an analogue switch (100) having an "on state" for passing of signals between an input (102) and an output (103), and an "off state" for blocking of signals between the input (102) and the output (103), the method comprising the steps of:
providing a first transistor (101) formed with an isolated body having one end of its conducting channel connected to the input (102) and the other end connected to the output (103),
setting a body potential (105) of the first transistor (101) to the potential of the input (102) or output (103) constituting the source of the first transistor (101),
controlling the gate of the first transistor (101) to set the switch (100) in the "on state" or the "off state", wherein setting of the gate of the first transistor (101) to the body potential (105) sets the switch (100) in the "off state", and setting the gate of the first transistor (101) to a voltage level that differs from the body potential (105) by a predefined drive voltage level sets the switch (100) in the "on state".

13. The method as claimed in claim 12, wherein the step of controlling the gate of the first transistor (101) comprises the sub-steps of:
measuring the body potential (105) of the first transistor (101),
generating a predefined drive voltage level, and
adding the predefined drive voltage level to the measured body potential (105).
